(19) Europäisches Patentamt
European Patent Office
Office européen des brevets

(11) **EP 4 614 169 A1**

(12) **EUROPEAN PATENT APPLICATION**
published in accordance with Art. 153(4) EPC

(43) Date of publication:
**10.09.2025 Bulletin 2025/37**

(21) Application number: **23891776.9**

(22) Date of filing: **30.08.2023**

(51) International Patent Classification (IPC):
*G01R 31/392* (2019.01)     *G01R 31/367* (2019.01)
*G01R 31/36* (2020.01)      *G01R 31/56* (2020.01)
*G01R 31/3835* (2019.01)    *H01M 10/052* (2010.01)
*H01M 10/48* (2006.01)

(52) Cooperative Patent Classification (CPC):
**G01R 31/36; G01R 31/367; G01R 31/3835;
G01R 31/392; G01R 31/56; H01M 10/052;
H01M 10/48**

(86) International application number:
**PCT/KR2023/012881**

(87) International publication number:
**WO 2024/106706 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.11.2022   KR 20220152985
16.08.2023   KR 20230107049**

(71) Applicant: **LG Energy Solution, Ltd.
Seoul 07335 (KR)**

(72) Inventors:
• **KIM, Hae Rin
Daejeon 34122 (KR)**
• **LIM, Jin Hyung
Daejeon 34122 (KR)**
• **KOH, Dong Wook
Daejeon 34122 (KR)**
• **JUN, Gwang Hoon
Daejeon 34122 (KR)**

(74) Representative: **Plasseraud IP
104 Rue de Richelieu
CS92104
75080 Paris Cedex 02 (FR)**

(54) **BATTERY DEGRADATION INSPECTION DEVICE AND METHOD FOR OPERATING SAME**

(57)     A deterioration inspection apparatus according to an embodiment disclosed herein includes a data obtaining unit configured to obtain, at a first timepoint, first data related to a first open circuit voltage (OCV) and a first state of health (SoH) of a battery and obtain, at a second timepoint, second data related to a second OCV and a second SoH of the battery, a capacity identifying unit configured to identify a theoretical capacity of a full cell at a reference timepoint from reference data related to the battery, and a calculating unit configured to calculate an OCV change amount between the first OCV and the second OCV and an SoH change amount between the first SoH and the second SoH and calculate an anode side reaction (ASR) and a cathode side reaction (CSR) at the second timepoint, based on the theoretical capacity of the full cell, the OCV change amount, and the SoH change amount.

FIG.1

**Description**

**[Technical Field]**

CROSS-REFERENCE TO RELATED APPLICATION

This application claims priority to and the benefit of Korean Patent Application No. 10-2022-0152985 filed in the Korean Intellectual Property Office on November 15, 2022, and Korean Patent Application No. 10-2023-0107049 filed in the Korean Intellectual Property Office on August 16, 2023, the entire contents of which are incorporated herein by reference.

TECHNICAL FIELD

Embodiments disclosed herein relate to a deterioration inspection apparatus for a battery and an operating method of the deterioration inspection apparatus.

**[Background Art]**

Increasing technological development and demands for mobile devices rapidly increase demands for secondary batteries. Lithium secondary batteries have been widely used as energy sources of various electronic products as well as various mobile devices due to high energy density and operating voltage and excellent preservation and lifetime characteristics.

Types of secondary batteries include lithium ion batteries, lithium polymer batteries, nickel cadmium batteries, nickel hydrogen batteries, nickel zinc batteries, and so forth. The lithium secondary batteries are classified into prismatic batteries, pouch-type batteries, and cylindrical batteries according to their shapes.

Recently, the secondary batteries have been widely used not only for small-size devices such as portable electronic devices, but also medium to large-size devices such as battery packs or power storage devices in hybrid or electric vehicles.

To predict the lifetime of the secondary batteries, deterioration degree analysis may be used. The degree of deterioration may be quantified by side reaction quantities (e.g., a loss of lithium inventory (LLI) and a loss of active materials (LAM)). Herein, the LLI may indicate how much lithium of a secondary battery is reduced from the beginning of life (BoL). An LAM of a positive electrode may indicate how much a positive active material of the secondary battery is reduced from the BoL. An LAM of a negative electrode may indicate how much a negative active material of the secondary battery is reduced from the BoL.

**[Disclosure]**

**[Technical Problem]**

However, conventional methods for quantifying side reaction quantities do not have consistent quantification methodology established depending on an experimental method, and deterioration degree estimation using only capacity fails to accurately reflect the degree of deterioration inside the actual battery.

Thus, to precisely analyze the degree of deterioration, battery decomposition analysis is required, requiring a lot of time and resources.

Accordingly, there is a need for a scheme to accurately and consistently estimate a side reaction quantity corresponding to battery deterioration in a non-destructive manner.

Technical problems of the embodiments disclosed herein are not limited to the above-described technical problems, and other unmentioned technical problems would be clearly understood by one of ordinary skill in the art from the following description.

**[Technical Solution]**

A deterioration inspection apparatus according to an embodiment disclosed herein includes a data obtaining unit configured to obtain, at a first timepoint, first data related to a first open circuit voltage (OCV) and a first state of health (SoH) of the battery and obtain, at a second timepoint, second data related to a second OCV and a second SoH of the battery, a capacity identifying unit configured to identify a theoretical capacity of a full cell at a reference timepoint from reference data related to the battery, and a calculating unit configured to calculate an OCV change amount between the first OCV and the second OCV and an SoH change amount between the first SoH and the second SoH and calculate an anode side reaction (ASR) and a cathode side reaction (CSR) at the second timepoint, based on the theoretical capacity of the full cell, the OCV change amount, and the SoH change amount.

In an embodiment, the reference timepoint may be a beginning of life (BoL).

In an embodiment, the calculating unit may be further configured to calculate the ASR and the CSR based on a capacity-positive electrode equilibrium potential slope and a capacity negative electrode equilibrium potential slope of the battery at the first timepoint.

In an embodiment, the reference data may be derived in advance through batteries of a same type as the battery.

In an embodiment, the calculating unit may be further configured to determine the ASR based on a product of the theoretical capacity and the SoH change amount, and the calculating unit may be further configured to determine the CSR based on the OCV change amount.

In an embodiment, the deterioration inspection apparatus may further include a model generating unit further configured to generate a model for identifying a SoH of a battery based on the calculated ASR and the calculated CSR.

In an embodiment, the deterioration inspection apparatus may further include an active material loss identifying unit further configured to identify an amount of change of active material losses between the first timepoint and the second timepoint, in which the model generating unit is further configured to generate the model for identifying the SoH of the battery further based on the amount of change of the active material losses.

An operating method of a deterioration inspection apparatus according to an embodiment disclosed herein includes obtaining, at a first timepoint, first data related to a first open circuit voltage (OCV) and a first state of health (SoH) of battery, obtaining, at a second timepoint, second data related to a second OCV and a second SoH of the battery, identifying a theoretical capacity of a full cell at a reference timepoint from reference data related to the battery, calculating an OCV change amount between the first OCV and the second OCV and an SoH change amount between the first SoH and the second SoH, and calculating an anode side reaction (ASR) and a cathode side reaction (CSR) at the second timepoint, based on the theoretical capacity, the OCV change amount, and the SoH change amount.

In an embodiment, the reference timepoint may be a beginning of life (BoL).

In an embodiment, the calculating of the ASR and the CSR may include calculating the ASR and the CSR based on a capacity-positive electrode equilibrium potential slope and a capacity negative electrode equilibrium potential slope of the battery at the first timepoint.

In an embodiment, the reference data may be derived in advance through batteries of a same type as the battery.

In an embodiment, the calculating of the ASR and the CSR may include determining the ASR based on a product of the theoretical capacity and the SoH change amount and determining, by the calculating unit, the CSR based on the OCV change amount.

In an embodiment, the operating method may further include generating a model for identifying a SoH of a battery based on the calculated ASR and CSR.

In an embodiment, the generating of the model may include identifying an amount of change of active material losses between the first timepoint and the second timepoint and generating the model for identifying the SoH of the battery further based on the amount of change of the active material losses.

**[Advantageous Effects]**

A deterioration inspection apparatus and an operating method thereof according to various embodiments disclosed herein may accurately and consistently estimate battery side reaction quantities according to battery deterioration.

The effects of the deterioration inspection apparatus and the operating method thereof according to the disclosure of the present document are not limited to the effects mentioned above, and other effects not mentioned will be clearly understood by those of ordinary skill in the art according to the disclosure of the present document.

**[Description of Drawings]**

FIG. 1 is a block diagram of a deterioration inspection apparatus according to various embodiments of the present disclosure.

FIG. 2 is a flowchart showing an operating method of a deterioration inspection apparatus according to an embodiment of the present invention.

FIG. 3A shows an implementation example of a deterioration inspection apparatus according to an embodiment of the present invention.

FIG. 3B shows an implementation example of a deterioration inspection apparatus according to an embodiment of the present invention.

FIG. 3C shows an implementation example of a deterioration inspection apparatus according to an embodiment of the present invention.

With regard to the description of the drawings, similar reference numerals may be used to refer to similar or related components.

**[Mode for Invention]**

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

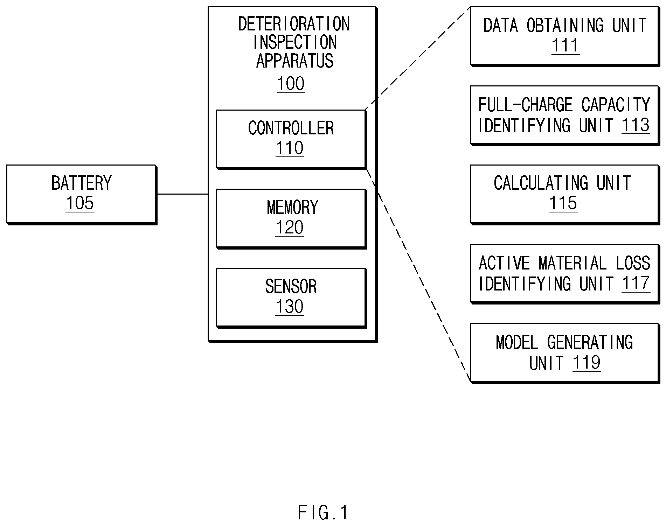

FIG. 1 is a block diagram of a deterioration inspection apparatus 100 according to various embodiments of the present disclosure.

Referring to FIG. 1, the deterioration inspection apparatus 100 may include a controller 110, a memory 120, and a sensor 130. In an embodiment, the deterioration inspection apparatus 100 may be a battery management system (BMS). In this case, a battery 105 may be a battery cell, a battery module, or a battery pack, and the deterioration inspection apparatus 100 may be implemented as one device together with the battery 105. In another embodiment, the deterioration inspection apparatus 100 may be a battery swapping station (BSS). When the deterioration inspection apparatus 100 is implemented with a battery swapping station, the deterioration inspection apparatus 100 may include a plurality of slots for storing and/or charging a plurality of battery modules. In another embodiment, the deterioration inspection apparatus 100 may be a server of a remote place. In this case, the battery 105 may be a device capable of communicating with the deterioration inspection apparatus 100.

In an embodiment, the controller 110 may execute software to control at least one other component (e.g., a hardware or software component) of the deterioration inspection apparatus 100 connected to the controller 110 and may process or compute various data.

In an embodiment, the controller 110 may include a data obtaining unit 111, a capacity identifying unit 113, a calculating unit 115, an active material loss identifying unit 117, a model generating unit 119, or a combination thereof. In an embodiment, the data obtaining unit 111, the capacity identifying unit 113, the calculating unit 115, the active material loss identifying unit 117, and/or the model generating unit 119 may be implemented with software.

In an embodiment, the memory 120 may include a volatile and/or a nonvolatile memory.

In an embodiment, the memory 120 may store data used by at least one component (e.g., the controller 110 or the sensor 130) of the deterioration inspection apparatus 100. For example, the data may include software (or an instruction related thereto), input data, or output data. In an embodiment, an instruction, when executed by the controller 110, may cause the deterioration inspection apparatus 100 to perform operations defined by the instruction.

In an embodiment, the sensor 130 may obtain information related to the battery 105. In an embodiment, the sensor 130 may obtain values (or information) related to a state of the battery 105. In an embodiment, the values related to the states may indicate one or more values of voltages, currents, resistances, states of charge (SoC), states of health (SoH), or temperatures of a battery cell or combinations thereof. Hereinbelow, the value related to the state may be referred to as a 'state value'.

In an embodiment, the sensor 130 may provide information (e.g., state values) of the battery 105 to the controller 110.

In an embodiment, the battery 105 may supply power to one or more components of the deterioration inspection apparatus 100. In an embodiment, the battery 105 may be attached to or detached from the deterioration inspection apparatus 100.

In an embodiment, the battery 105 may include one or more battery modules. In an embodiment, each of the one or more battery modules may include one or more battery cells. In an embodiment, the one or more battery cells may be connected to one another in series and/or in parallel.

Hereinafter, referring to FIG. 1, a method, performed by the deterioration inspection apparatus 100, of calculating an anode side reaction (ASR) and a cathode side reaction (CSR) of the battery 105 will be described.

In an embodiment, the data obtaining unit 111 may periodically obtain state values of the battery 105. In an embodiment, the data obtaining unit 111 may obtain state values of the battery 105 every designated charging/discharging cycles.

In an embodiment, the data obtaining unit 111 may obtain state values of the battery 105 by using the sensor 130. In an embodiment, the data obtaining unit 111 may obtain state values of the battery 105 by using a reference performance test (RPT). Herein, the RPT may refer to a test for obtaining a voltage, a current, a resistance, a state of charge (SoC), a state of health (SoH), or a temperature of the battery 105, or a combination thereof by charging and discharging the battery 105.

For example, the data obtaining unit 111 may obtain first data related to a first open circuit voltage (OCV) and a first SoH of the battery 105, at a first timepoint. Thereafter, at a second timepoint following the first timepoint, the data obtaining unit 111 may obtain second data related to a second OCV and a second SoH of the battery 105.

In an embodiment, the obtained first data and second data may be stored in the memory 120.

In an embodiment, the capacity identifying unit 113 may identify a theoretical capacity of a full cell at a reference timepoint from reference data related to the battery 105. In an embodiment, the reference timepoint may be a beginning of life (BoL) of the battery 105. In an embodiment, the reference data may refer to data previously derived from batteries of the same type as the battery 105. In an embodiment, the reference data may be referred to as a design parameter. In an embodiment, the reference data may include information about an open circuit potential (OCP) of a positive electrode, an OCP of a negative electrode, and a full cell OCV. In an embodiment, the reference data may include information about a value of an OCV (and/or OCP) with respect to an SOC. In an embodiment, the reference data may include information about a rate of change of an OCV (and/or OCP) with respect to an SOC.

In an embodiment, the calculating unit 115 may calculate an OCV change amount between a first OCV and a second OCV. In an embodiment, the calculating unit 115 may calculate a SoH change amount between a first SoH and a second SoH.

In an embodiment, the calculating unit 115 may calculate an ASR and a CSR at a second timepoint, based on the theoretical capacity of the full cell, the OCV change amount, and the SoH change amount. More specifically, the calculating unit 115 may calculate the ASR and the CSR at the second timepoint, based on an equation provided below.

[Equation 1]

$$\begin{bmatrix} \triangle C_{ASR} \\ \triangle C_{CSR} \end{bmatrix} = \begin{bmatrix} 1 & -1 \\ \dfrac{\partial U_n^{k-1}}{\partial C} & -\dfrac{\partial U_p^{k-1}}{\partial C} \end{bmatrix}^{-1} \begin{bmatrix} -\triangle SOH_{OCV} \cdot c_{OCV,fullcell}^{k=0} \\ \triangle OCV \end{bmatrix}$$

In Equation 1, $\triangle C_{ASR}$ may indicate a change amount of a side reaction quantity of a positive electrode between the first timepoint (k-1) and the second timepoint (k), and $\triangle C_{CSR}$ may indicate a change amount of a side reaction quantity of a negative electrode between the first timepoint (k-1) and the second timepoint (k).

In Equation 1, $\dfrac{\partial U_n^{k-1}}{\partial C}$ may indicate a slope of a capacity (c)-negative electrode equilibrium potential ( $U_n^{k-1}$ ) at the timepoint (k-1), and $\dfrac{\partial U_p^{k-1}}{\partial C}$ may indicate a slope of a capacity (c)-positive electrode equilibrium potential ( $U_p^{k-1}$ ) at the timepoint (k-1).

In Equation 1, $\triangle SOH_{OCV}$ may indicate the amount of change of an SoH at a designated voltage. $c_{OCV,fullcell}^{k=0}$ may mean a theoretical capacity except for overpotential in a designated voltage range at the reference timepoint (i.e., a timepoint when k is 0, or the BoL). The OCV may mean the amount of change of OCV. Herein, (k-1) may mean the first timepoint, and k may mean the second timepoint. The amounts of change in Equation 1 may be identified by a value at the second timepoint with respect to a value of the first timepoint.

In an embodiment, $\dfrac{\partial U_n^{k-1}}{\partial C}$ may be calculated based on Equation 2.

[Equation 2]

$$\frac{\partial U_p^{k-1}}{\partial C} = \frac{\partial U_p^{y=y^{k-1}}}{\partial y} \cdot \frac{\partial y}{\partial C} = -\frac{\dfrac{\partial U_p^{y=y^{k-1}}}{\partial y}}{c_{OCV,p}^{k=0}}$$

$$\frac{\partial U_n^{k-1}}{\partial C} = \frac{\partial U_n^{x=x^{k-1}}}{\partial x} \cdot \frac{\partial x}{\partial C} = \frac{\dfrac{\partial U_n^{x=x^{k-1}}}{\partial x}}{c_{OCV,n}^{k=0}}$$

Referring to Equation 2, $\dfrac{\partial U_n^{k-1}}{\partial C}$ may be calculated based on a product of the amount of change $\dfrac{\partial U_n^{k-1}}{\partial x}$ of a negative potential at the timepoint (k-1) with respect to the negative electrode stoichiometry and the amount of change of a capacity-negative electrode stoichiometry. Moreover, the amount of change of the capacity-negative electrode stoichiometry may be replaced with $C_{OCV,n}^{k=0}$ indicating a negative electrode capacity in a designated voltage range. Herein, the amount of change of the negative potential at the timepoint (k-1) with respect to the negative electrode stoichiometry and the amount of change of the capacity-negative electrode stoichiometry may be included in the reference data.

In an embodiment, $\dfrac{\partial U_p^{k-1}}{\partial C}$ may be calculated based on Equation 3.

[Equation 3]

$$\frac{\partial U_p^{k-1}}{\partial C} = \frac{\partial U_p^{y=y\,k-1}}{\partial y} \cdot \frac{\partial y}{\partial C} = -\frac{\dfrac{\partial U_p^{y=y\,k-1}}{\partial y}}{C_{OCV,p}^{k=0}}$$

$$\frac{\partial U_n^{k-1}}{\partial C} = \frac{\partial U_n^{x=x\,k-1}}{\partial X} \cdot \frac{\partial X}{\partial C} = \frac{\dfrac{\partial U_n^{x=x\,k-1}}{\partial X}}{C_{OCV,n}^{k=0}}$$

Referring to Equation 3, $\dfrac{\partial U_p^{k-1}}{\partial C}$ may be calculated based on a product of the amount of change of a positive potential at the timepoint (k-1) with respect to the positive electrode stoichiometry and the amount of change of a capacity-positive electrode stoichiometry. Moreover, the amount of change of the capacity-positive electrode stoichiometry may be replaced with $-C_{OCV,p}^{k=0}$ indicating a positive electrode capacity in a designated voltage range. Herein, the amount of change of the positive potential at the timepoint (k-1) with respect to the positive electrode stoichiometry and the amount of change of the capacity-positive electrode stoichiometry may be included in the reference data.

In an embodiment, the calculating unit 115 may calculate the ASR and the CSR based on the capacity-positive electrode equilibrium potential slope $\dfrac{\partial U_p^{k-1}}{\partial C}$ and the capacity-negative electrode equilibrium potential slope $\dfrac{\partial U_n^{k-1}}{\partial C}$ of the battery 105 at the first timepoint (i.e., k-1), as shown in Equation 1.

In an embodiment, the calculating unit 115 may determine the ASR based on a product of a theoretical capacity of the full cell and an SoH change amount $\triangle SOH_{OCV}$, and determine the CSR based on an OCV change amount $\triangle OCV$, as shown in Equation 1.

Hereinbelow, a description will be made of a method, performed by the deterioration inspection apparatus 100, of calculating the ASR and the CSR of the battery 105 further based on a loss of active materials (LAM).

In an embodiment, the calculating unit 115 may calculate the ASR and the CSR at the second timepoint, further based on a loss of active materials. In an embodiment, the calculating unit 115 may calculate the ASR and the CSR at the second timepoint, based on Equation 4 provided below.

[Equation 4]

$$\begin{bmatrix} \triangle c_{ASR} \\ \triangle c_{CSR} \\ \triangle \delta_{LAM,p} \end{bmatrix} = \begin{bmatrix} 1 & -1 & -\left(y_{SOC100}-y_{0p}^{k-1}\right)\cdot c_{OCV,p}^{k=0} \\ \dfrac{\partial U_n^{k-1}}{\partial c_{SOC,Op}} & -\dfrac{\partial U_p^{k-1}}{\partial c_{SOC,Op}} & 0 \\ \dfrac{\partial U_n^{k-1}}{\partial c_{SOC50}} & -\dfrac{\partial U_p^{k-1}}{\partial c_{SOC50}} & -\dfrac{\partial U_p^{k-1}}{\partial c_{SOC50}}\left(y_{SOC50}^{k-1}-y_{0p}^{k-1}\right)\cdot c_{OCV,p}^{k=0} \end{bmatrix}^{-1} \begin{bmatrix} -\triangle SOH_{OCV}\cdot c_{OCV,fullcell}^{k=0} \\ \triangle OCV_{SOC,Op} \\ \triangle OCV_{SOC,50} \end{bmatrix}$$

In Equation 4, $\triangle\delta_{LAM,p}$ may indicate the amount of change of a loss of positive electrode active materials.

In Equation 4, $\dfrac{\partial U_n^{k-1}}{\partial c_{SOC,op}}$ may indicate a slope of a capacity ($c_{SOC,op}$)- negative electrode equilibrium potential ( $U_n^{k-1}$ ) at the timepoint (k-1), and $\dfrac{\partial U_p^{k-1}}{\partial c_{SOC,op}}$ may indicate a slope of a capacity ($c_{SOC,op}$)-positive electrode equilibrium potential ( $U_p^{k-1}$ ) at the timepoint (k-1). $\dfrac{\partial U_n^{k-1}}{\partial c_{SOC50}}$ may indicate a slope of a capacity ($c_{SOC50}$)-negative electrode equilibrium potential ( $U_n^{k-1}$ ) at a point corresponding to an SoC of 50 % at the timepoint (k-1), and $\dfrac{\partial U_p^{k-1}}{\partial c_{SOC50}}$ may indicate a slope of a capacity ($c_{SOC50}$)-positive electrode equilibrium potential ( $U_p^{k-1}$ ) at a point corresponding to an SoC of 50 % at the timepoint (k-1). $c_{OCV,p}^{k=0}$ may mean a positive electrode capacity in a designated voltage range at the reference timepoint (i.e., a timepoint when k is 0, or the BoL). ySoC100 may mean a negative electrode stoichiometry at a point corresponding to an SoC of 100 %, and $y_{0p}^{k=0}$ may mean a positive electrode stoichiometry at a stored SoC point at a timepoint of k = 0.

In Equation 4, $\triangle OCV_{SOC,Op}$ may indicate the amount of change of OCV at the stored SoC point. $\triangle OCV_{SOC,Op}$ may indicate the amount of change of OCV at a point corresponding to an SoC of 50 %. Herein, slopes of a capacity-equilibrium potential, stoichiometries, and capacities may be included in reference data.

In an embodiment, the calculating unit 115 may calculate the ASR and the CSR based on a capacity-negative electrode equilibrium potential slope at a point corresponding to an SoC of 50 % as shown in Equation 4. In an embodiment, the calculating unit 115 may calculate the ASR and the CSR based on a capacity-positive electrode equilibrium potential slope at a stored SoC point as shown in Equation 4.

In an embodiment, the calculating unit 115 may determine the ASR based on a product of a theoretical capacity of the full cell and an SoH change amount $\triangle SOH_{OCV}$, and determine the CSR based on an OCV change amount $\triangle OCV$ at the stored SoC point, as shown in Equation 4.

Hereinbelow, a description will be made of a method, performed by the deterioration inspection apparatus 100, of generating a model for identifying a SoH of a battery based on the calculated ASR and CSR.

In an embodiment, the deterioration inspection apparatus 100 may further include the active material loss identifying unit 117.

In an embodiment, the active material loss identifying unit 117 may identify a loss of active materials at each of at least two timepoints. For example, the active material loss identifying unit 117 may identify a loss of active materials at each of the first timepoint and the second timepoint. Herein, the loss of active materials may include a negative electrode active material loss and a positive electrode active material loss.

In an embodiment, the active material loss identifying unit 117 may identify the loss of active materials based on a differential shape of charge and discharge data. For example, the active material loss identifying unit 117 may classify a positive electrode capacity loss, a negative electrode capacity loss, and a balance shift of the battery 105 based on a change of a peak value of dV/dQ. Thereafter, the active material loss identifying unit 117 may identify the negative electrode active material loss and the positive electrode active material loss.

The model generating unit 119 may generate a model for identifying a SoH and/or an SoC of a battery based on the calculated ASR and CSR. For example, the model may be a model for selecting a profile corresponding to the LLI (e.g., the ASR and the CSR) and/or the LAM (e.g., a positive electrode LAM and a negative electrode LAM) from among a plurality of profiles (e.g., SoH profiles, SoC profiles).

Thereafter, the deterioration inspection apparatus 100 may select a profile corresponding to the LLI (e.g., the ASR and the CSR) and/or the LAM (e.g., the positive electrode LAM and the negative electrode LAM) by using the generated model and identify the SoH and/or the SoC of the battery from the selected profile.

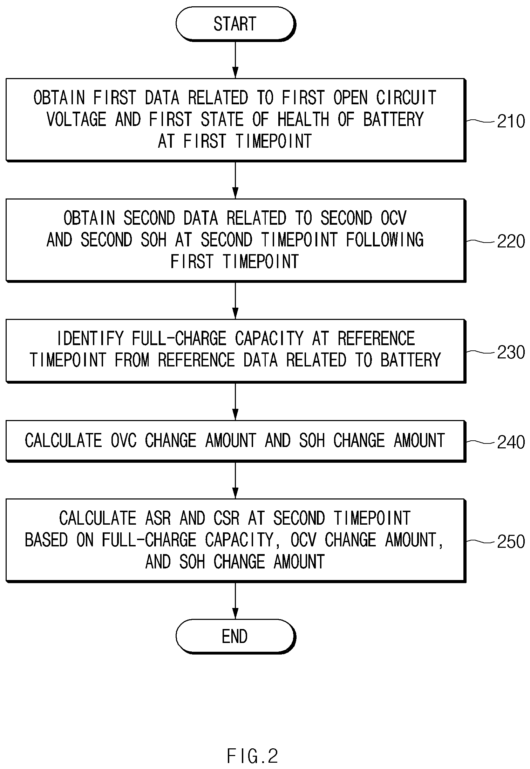

FIG. 2 is a flowchart showing an operating method of a deterioration inspection apparatus 210 according to an embodiment of the present invention.

Referring to FIG. 2, in operation 210, the deterioration inspection apparatus 100 may obtain the first data related to the first OCV and the first SoH of the battery 105 at the first timepoint. In an embodiment, the deterioration inspection apparatus 100 may obtain state values of the battery 105 by performing an RPT at the first timepoint. Herein, the RPT may refer to a test for obtaining a voltage, a current, a resistance, an SoC, a SoH, or a temperature of the battery 105, or a combination thereof by charging and discharging the battery 105. In an embodiment, the values related to the states may indicate one or more values of voltages, currents, resistances, SoC, SoH, or temperatures of a battery cell or combinations thereof.

In operation 220, the deterioration inspection apparatus 100 may obtain the second data related to the second OCV and the second SoH of the battery 105 at the first timepoint. In an embodiment, the deterioration inspection apparatus 100 may obtain state values of the battery 105 by performing an RPT at the second timepoint.

In operation 230, the deterioration inspection apparatus 100 may identify the theoretical capacity at the reference timepoint from the reference data related to the battery 105. In an embodiment, the deterioration inspection apparatus 100 may identify the theoretical capacity of the full cell at the reference timepoint from the reference data related to the battery 105. In an embodiment, the reference timepoint may be a BoL of the battery 105. In an embodiment, the reference data may refer to data previously derived from batteries of the same type as the battery 105. In an embodiment, the reference data may be referred to as a design parameter. In an embodiment, the reference data may include information about an OCP of a positive electrode, an OCP of a negative electrode, and a full cell OCV. In an embodiment, the reference data may include information about a value of an OCV (and/or OCP) with respect to an SOC. In an embodiment, the reference data may include information about a rate of change of an OCV (and/or OCP) with respect to an SOC.

In operation 240, the deterioration inspection apparatus 100 may calculate an OCV change amount and a SoH change amount. In an embodiment, the deterioration inspection apparatus 100 may calculate the OCV change amount between the first OCV and the second OCV. In an embodiment, the deterioration inspection apparatus 100 may calculate the SoH change amount between the first SoH and the second SoH.

In operation 250, the deterioration inspection apparatus 100 may calculate the ASR and the CSR at the second timepoint based on the theoretical capacity, the OCV change amount, and the SoH change amount.

More specifically, the deterioration inspection apparatus 100 may calculate the ASR and the CSR based on the capacity-positive electrode equilibrium potential slope and the capacity-negative electrode equilibrium potential slope of the battery 105 at the first timepoint (i.e., k-1). In an embodiment, the deterioration inspection apparatus 100 may determine the ASR based on the product of the theoretical capacity of the full cell and the SoH change amount, and determine the CSR based on the OCV change amount.

In an embodiment, the deterioration inspection apparatus 100 may calculate the ASR and the CSR based on the capacity-negative electrode equilibrium potential slope at a point corresponding to an SoC of 50 %. In an embodiment, the deterioration inspection apparatus 100 may calculate the ASR and the CSR based on the capacity-positive electrode equilibrium potential slope at the stored SoC point.

In an embodiment, the deterioration inspection apparatus 100 may determine the ASR based on the product of the theoretical capacity of the full cell and the SoH change amount, and determine the CSR based on the stored SoC point.

Thereafter, the deterioration inspection apparatus 100 may generate a model for identifying a SoH and/or an SoC of a battery based on the calculated ASR and CSR. For example, the model may be a model for selecting a profile corresponding to the LLI (e.g., the ASR and the CSR) from among a plurality of profiles (e.g., SoH profiles, SoC profiles).

The deterioration inspection apparatus 100 may generate a model for identifying the SoH and/or the SoC of the battery further based on the positive electrode LAM and the negative electrode LAM. For example, the model may be a model for selecting a profile corresponding to the LLI (e.g., the ASR and the CSR) and/or the LAM (e.g., a positive electrode LAM and a negative electrode LAM) from among a plurality of profiles (e.g., SoH profiles, SoC profiles). Herein, the LAM may include the negative electrode LAM and the positive electrode LAM.

In an embodiment, the negative electrode LAM and the positive electrode LAM may be identified based on the differential shape of charge and discharge data of the battery 105. For example, the negative electrode LAM and the positive electrode LAM may be identified based on a change of a peak value of dV/dQ. The LAM of the battery 105 may be classified into a positive electrode capacity loss, a negative electrode capacity loss, and a balance shift, based on a change of a peak value of dV/dQ.

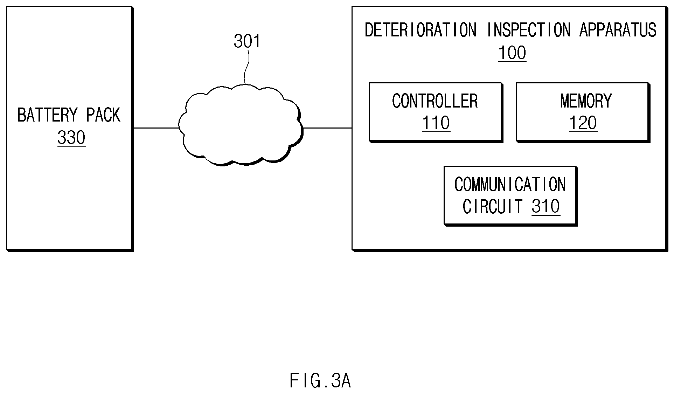

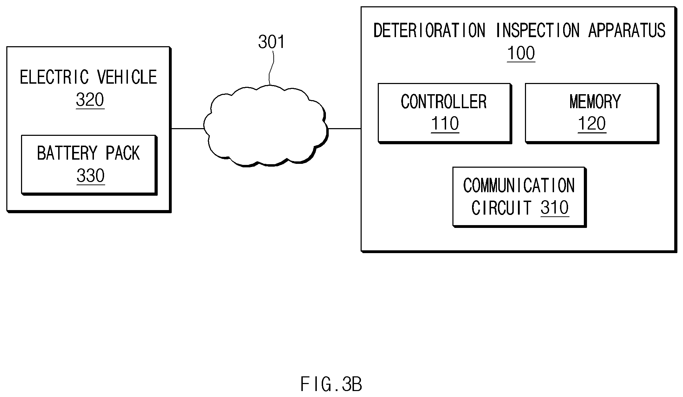

FIG. 3A shows an implementation example of the deterioration inspection apparatus 100 according to an embodiment of the present invention. FIG. 3B shows an implementation example of the deterioration inspection apparatus 100 according to an embodiment of the present invention.

Referring to FIG. 3A, the deterioration inspection apparatus 100 may include a communication circuit 310 in place of the sensor 130. In an embodiment, the communication circuit 310 may establish a wired communication channel and/or a wireless communication channel between the deterioration inspection apparatus 100 and a battery pack 330, and transmit and receive data to and from the battery pack 330 through the established communication channel. According to an embodiment, the deterioration inspection apparatus 100 may include the sensor 130 and the communication circuit 310.

In an embodiment, the deterioration inspection apparatus 100 may be connected to the battery pack 330. In an embodiment, the network 301 may include a short-range communications network (e.g., Bluetooth, wireless fidelity (Wi-Fi), and/or infrared data association (IrDA)), or a long-range communication network (e.g., a legacy cellular network, a 5<sup>th</sup> Generation (5G) network, the Internet, or a computer network (e.g., a local area network (LAN) or wide area network (WAN)).

In an embodiment, the deterioration inspection apparatus 100 may be connected directly or indirectly to the battery pack 330. In an embodiment, the deterioration inspection apparatus 100 may obtain information related to the battery pack 330 through the communication circuit 310. In an embodiment, the deterioration inspection apparatus 100 may obtain values (or information) related to a state of the battery pack 330 through the communication circuit 310.

In an embodiment, when the battery pack 330 is included in an electric vehicle 320 as shown in FIG. 3B, the deterioration inspection apparatus 100 may perform data communication with the battery pack 330 through a communication circuit of the electric vehicle 320.

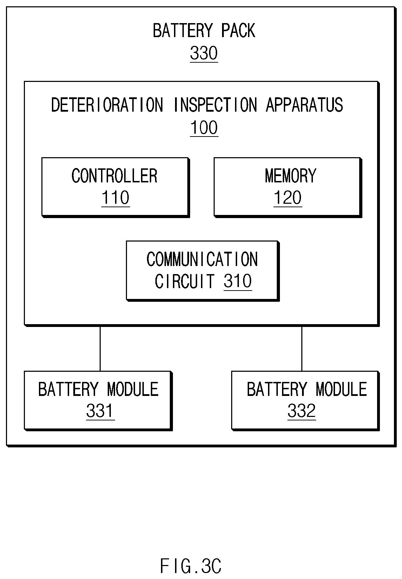

FIG. 3C shows an implementation example of the deterioration inspection apparatus 100 according to an embodiment of the present invention.

Referring to FIG. 3C, the deterioration inspection apparatus 100 may be formed integrally with the battery pack 330. In this case, the deterioration inspection apparatus 100 may obtain data directly from battery modules 331 and 332 of the battery pack 330.

**Claims**

1. A deterioration inspection apparatus comprising:

    a data obtaining unit configured to obtain, at a first timepoint, first data related to a first open circuit voltage (OCV) and a first state of health (SoH) of a battery and obtain, at a second timepoint, second data related to a second OCV and a second SoH of the battery;
    a capacity identifying unit configured to identify a theoretical capacity of a full cell at a reference timepoint from reference data related to the battery; and
    a calculating unit configured to calculate an OCV change amount between the first OCV and the second OCV and a SoH change amount between the first SoH and the second SoH and calculate an anode side reaction (ASR) and a cathode side reaction (CSR) at the second timepoint, based on the theoretical capacity of the full cell, the OCV change amount, and the SoH change amount.

2. The deterioration inspection apparatus of claim 1, wherein the reference timepoint is a beginning of life (BoL).

3. The deterioration inspection apparatus of claim 1, wherein the calculating unit is further configured to calculate the ASR and the CSR based on a capacity-positive electrode equilibrium potential slope and a capacity-negative electrode equilibrium potential slope of the battery at the first timepoint.

4. The deterioration inspection apparatus of claim 1, wherein the reference data is derived in advance through batteries of a same type as the battery.

5. The deterioration inspection apparatus of claim 1, wherein the calculating unit is further configured to determine the ASR based on a product of the theoretical capacity and the SoH change amount, and
the calculating unit is further configured to determine the CSR based on the OCV change amount.

6. The deterioration inspection apparatus of claim 1, further comprising a model generating unit further configured to generate a model for identifying a SoH of a battery based on the calculated ASR and the calculated CSR.

7. The deterioration inspection apparatus of claim 6, further comprising an active material loss identifying unit further configured to identify an amount of change of active material losses between the first timepoint and the second timepoint, and
wherein the model generating unit is further configured to generate the model for identifying the SoH of the battery further based on the amount of change of the active material losses.

8. An operating method of a deterioration inspection apparatus, the operating method comprising:

obtaining, at a first timepoint, first data related to a first open circuit voltage (OCV) and a first state of health (SoH) of a battery;
obtaining, at a second timepoint, second data related to a second OCV and a second SoH of the battery;
identifying a theoretical capacity of a full cell at a reference timepoint from reference data related to the battery;
calculating an OCV change amount between the first OCV and the second OCV and a SoH change amount between the first SoH and the second SoH; and
calculating an anode side reaction (ASR) and a cathode side reaction (CSR) at the second timepoint, based on the theoretical capacity, the OCV change amount, and the SoH change amount.

9. The operating method of claim 8, wherein the reference timepoint is a beginning of life (BoL).

10. The operating method of claim 8, wherein the calculating of the ASR and the CSR comprises calculating the ASR and the CSR based on the capacity-positive electrode equilibrium potential slope and a capacity-negative electrode equilibrium potential slope of the battery at the first timepoint.

11. The operating method of claim 8, wherein the reference data is derived in advance through batteries of a same type as the battery.

12. The operating method of claim 8, wherein
the calculating of the ASR and the CSR comprises:

determining the ASR based on a product of the theoretical capacity and the SoH change amount; and
determining, by the calculating unit, the CSR based on the OCV change amount.

13. The operating method of claim 8, further comprising generating a model for identifying a SoH of a battery based on the calculated ASR and CSR.

14. The operating method of claim 13, wherein the generating of the model comprises:

identifying an amount of change of active material losses between the first timepoint and the second timepoint; and
generating the model for identifying the SoH of the battery further based on the amount of change of the active material losses.

DETERIORATION INSPECTION APPARATUS 100

CONTROLLER 110

MEMORY 120

SENSOR 130

BATTERY 105

DATA OBTAINING UNIT 111

FULL-CHARGE CAPACITY IDENTIFYING UNIT 113

CALCULATING UNIT 115

ACTIVE MATERIAL LOSS IDENTIFYING UNIT 117

MODEL GENERATING UNIT 119

FIG.1

```
                    ┌─────────────┐
                    │    START    │
                    └──────┬──────┘
                           │
                           ▼
    ┌───────────────────────────────────────────────┐
    │ OBTAIN FIRST DATA RELATED TO FIRST OPEN CIRCUIT│
    │  VOLTAGE AND FIRST STATE OF HEALTH OF BATTERY  │──── 210
    │              AT FIRST TIMEPOINT                │
    └───────────────────────┬───────────────────────┘
                            │
                            ▼
    ┌───────────────────────────────────────────────┐
    │    OBTAIN SECOND DATA RELATED TO SECOND OCV     │
    │  AND SECOND SOH AT SECOND TIMEPOINT FOLLOWING  │──── 220
    │              FIRST TIMEPOINT                    │
    └───────────────────────┬───────────────────────┘
                            │
                            ▼
    ┌───────────────────────────────────────────────┐
    │     IDENTIFY FULL-CHARGE CAPACITY AT REFERENCE  │
    │ TIMEPOINT FROM REFERENCE DATA RELATED TO BATTERY│──── 230
    └───────────────────────┬───────────────────────┘
                            │
                            ▼
    ┌───────────────────────────────────────────────┐
    │ CALCULATE OVC CHANGE AMOUNT AND SOH CHANGE AMOUNT│──── 240
    └───────────────────────┬───────────────────────┘
                            │
                            ▼
    ┌───────────────────────────────────────────────┐
    │    CALCULATE ASR AND CSR AT SECOND TIMEPOINT    │
    │ BASED ON FULL-CHARGE CAPACITY, OCV CHANGE AMOUNT,│──── 250
    │           AND SOH CHANGE AMOUNT                 │
    └───────────────────────┬───────────────────────┘
                            │
                            ▼
                    ┌─────────────┐
                    │     END     │
                    └─────────────┘
```

FIG.2

FIG.3A

ELECTRIC VEHICLE
320

BATTERY PACK
330

301

DETERIORATION INSPECTION APPARATUS
100

CONTROLLER
110

MEMORY
120

COMMUNICATION
CIRCUIT 310

FIG.3B

BATTERY PACK
330

DETERIORATION INSPECTION APPARATUS
100

CONTROLLER
110

MEMORY
120

COMMUNICATION
CIRCUIT 310

BATTERY MODULE
331

BATTERY MODULE
332

FIG.3C

## INTERNATIONAL SEARCH REPORT

| International application No. |
|---|
| **PCT/KR2023/012881** |

| A. | CLASSIFICATION OF SUBJECT MATTER |
|---|---|

**G01R 31/392**(2019.01)i; **G01R 31/367**(2019.01)i; **G01R 31/36**(2006.01)i; **G01R 31/56**(2020.01)i; **G01R 31/3835**(2019.01)i; **H01M 10/052**(2010.01)i; **H01M 10/48**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 개방회로전압(open circuit voltage), 전지(battery), 건강 상태(state of health), 풀셀 (full cell), 부반응(side reaction), 퇴화(atrophy)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2021-0074004 A (LG ENERGY SOLUTION, LTD.) 21 June 2021 (2021-06-21)<br>See paragraph [0089] and claims 1-6. | 1-14 |
| Y | KR 10-2022-0139755 A (LG ENERGY SOLUTION, LTD.) 17 October 2022 (2022-10-17)<br>See claims 1-7 and figures 7-10. | 1-14 |
| Y | KR 10-2452626 B1 (LG ENERGY SOLUTION, LTD.) 06 October 2022 (2022-10-06)<br>See claims 1-6. | 1-14 |
| Y | KR 10-1504804 B1 (LG CHEM, LTD.) 20 March 2015 (2015-03-20)<br>See claim 1. | 6-7,13-14 |
| A | US 2019-0064283 A1 (SAFT) 28 February 2019 (2019-02-28)<br>See entire document. | 1-14 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 December 2023** | **11 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/012881**

| Patent document cited in search report | | | Publication date (day/month/year) | Patent family member(s) | | | Publication date (day/month/year) |
|---|---|---|---|---|---|---|---|
| KR | 10-2021-0074004 | A | 21 June 2021 | CN | 114402211 | A | 26 April 2022 |
| | | | | EP | 4024071 | A1 | 06 July 2022 |
| | | | | EP | 4024071 | A4 | 30 November 2022 |
| | | | | JP | 2022-548516 | A | 21 November 2022 |
| | | | | JP | 7332098 | B2 | 23 August 2023 |
| | | | | WO | 2021-118311 | A1 | 17 June 2021 |
| KR | 10-2022-0139755 | A | 17 October 2022 | CN | 115803937 | A | 14 March 2023 |
| | | | | EP | 4199182 | A1 | 21 June 2023 |
| | | | | JP | 2023-530691 | A | 19 July 2023 |
| | | | | US | 2023-0296688 | A1 | 21 September 2023 |
| | | | | WO | 2022-215962 | A1 | 13 October 2022 |
| KR | 10-2452626 | B1 | 06 October 2022 | CN | 110869784 | A | 06 March 2020 |
| | | | | EP | 3674728 | A1 | 01 July 2020 |
| | | | | EP | 3674728 | A4 | 16 December 2020 |
| | | | | JP | 2020-524803 | A | 20 August 2020 |
| | | | | JP | 6969062 | B2 | 24 November 2021 |
| | | | | KR | 10-2019-0106126 | A | 18 September 2019 |
| | | | | US | 11415631 | B2 | 16 August 2022 |
| | | | | US | 2020-0150183 | A1 | 14 May 2020 |
| | | | | WO | 2019-172527 | A1 | 12 September 2019 |
| KR | 10-1504804 | B1 | 20 March 2015 | KR | 10-2013-0136800 | A | 13 December 2013 |
| US | 2019-0064283 | A1 | 28 February 2019 | CN | 109154635 | A | 04 January 2019 |
| | | | | CN | 109154635 | B | 08 January 2021 |
| | | | | EP | 3443370 | A1 | 20 February 2019 |
| | | | | EP | 3443370 | B1 | 04 March 2020 |
| | | | | FR | 3050278 | A1 | 20 October 2017 |
| | | | | FR | 3050278 | B1 | 20 October 2017 |
| | | | | US | 11035906 | B2 | 15 June 2021 |
| | | | | WO | 2017-178563 | A1 | 19 October 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220152985

- KR 1020230107049